# EUROPEAN PATENT SPECIFICATION

(11) **EP 3 419 040 B1**
(45) Date of publication and mention of the grant of the patent: **14.10.2020**
(21) Application number: 17177105.8
(22) Date of filing: 21.06.2017
(51) Int. Cl.: H01H 71/02, H01H 71/12, H01H 71/74, G05B 19/418, G01R 21/133

(54) **ADD-ON MODULE FOR A DIN RAIL-MOUNTED ELECTRICAL DEVICE**
ZUSATZMODUL FÜR EINE AN EINER DIN-SCHIENE MONTIERTE ELEKTRISCHE VORRICHTUNG
MODULE COMPLÉMENTAIRE POUR UN DISPOSITIF ÉLECTRIQUE MONTÉ SUR RAIL DIN

(43) Date of publication of application: 26.12.2018
(73) Proprietor: Enexo AB, 22480 Lund (SE)
(72) Inventor: Lindström, Magnus, 22480 Lund (SE)
(74) Representative: Høiberg P/S

(56) References cited:
- EP-A2- 0 779 640
- WO-A1-2014/009976
- DE-C1- 19 653 714
- US-A1- 2010 264 906

## Description

The present disclosure relates to an add-on module for a DIN rail-mounted electrical device, such as a circuit breaker. The add-on module can be externally connected to a circuit breaker to measure values and/or control a state of the electrical device.

### Background of invention

A DIN rail is a metal rail of a standard type widely used for mounting circuit breakers and other electrical devices, such as industrial control equipment in equipment racks. DIN rails are also used for *inter alia* transmitter equipment, power supply devices, monitoring devices and residual-current devices. The term derives from the original specifications published by Deutsches Institut für Normung (DIN) in Germany, which have since been adopted as European (EN) and international (IEC) standards.

A circuit breaker is an automatically operated electrical switch designed to protect an electrical circuit or a group of devices from damage caused by excess current, typically resulting from an overload or short circuit. A circuit breaker can be seen as an overcurrent protective device. Its basic function is to interrupt current flow after a fault is detected. A circuit breaker is typically adjusted to a certain maximum amount of current that may be used for a specific group of devices. A residual-current device is a device that instantly breaks an electric circuit to prevent harm from an ongoing electric shock.

Home automation technology has introduced extensive control and automation of lighting, ventilation, heating, surveillance and control of almost any electrical device in a building. Circuit breakers, residual-current devices and other DIN rail-mounted electrical devices are no exception - additional features are integrated in e.g. circuit breakers with the purpose of for example optimizing power consumption, improving protection and overall increasing the controllability of the circuit breaker.

However, such smart circuit breakers are also more expensive and complex than conventional circuit breakers. Circuit breakers are critical for maintaining safety of homes. Therefore, any interference with functionality in circuit breakers, which is usually done in some aspect in smart circuit breakers, has to take into account several requirements and safety regulations, which may add further complexity and/or restrictions to the smart circuit breaker. This presents a further inconvenience for smart circuit breakers.

US 2010/264906 A1 discloses a device for measurement of power consumption at points of interest, including circuit breakers. The device has an inductive coupling for measuring the current.

WO 2014/009976 A1 discloses a circuit branch measurement device comprising a current sensor. The circuit branch measurement device is using current transformer, split-core current transformer or Hall effect sensor in the available embodiments.

EP 0 779 640 A2 discloses a a bus communication unit that transmits a signal to a breaker unit. The device is a bus-compatible amplifier module for electromagnetic drive arrangements of electromagnetic switching devices, which contains an electromagnetic or electronic amplifier arrangement, which has a bidirectional interface circuit with bus connections.

DE 196 53 714 C1 discloses a device that transmits control signals between a bus-line and a number of controlled valves of a valve block via interface elements with input and output contacts for connecting the interface elements in series. Each interface element is associated with at least one valve. The disclosure addresses control of communication busses for vents.

### Summary of invention

Accordingly, it is an object of the present invention to overcome the above mentioned challenges. The present disclosure relates to an add-on module which operates outside the electrical device, for example a circuit breaker, and is arranged to carry out measurement tasks, such as measuring the current, and/or controlling the signal passing through the unit, for example by interrupting the signal, thereby disconnecting the device. The module has a, preferably wireless, communication interface, such as ZigBee or Z-wave, and can be integrated in a smart home. The module is connected serially to the electrical device (which has one cable connected on the upper side and one cable connected on the lower side) by removing one of the cables, inserting it into the module and plugging the module, which has a pin/plug that fits the contactor of the circuit breaker, and may be arrangeable as a serial extension of the electrical device

The present disclosure relates to an add-on module (1) for a DIN rail-mounted circuit breaker (2), said add-on module configured to measure at least one electrical parameter of the circuit breaker (2), comprising:
- at least one sensor (19) configured to measure the at least one electrical parameter;
- a microprocessor (MC) for communicating the at least one electrical parameter to a secondary device (20), and for controlling a state of the circuit breaker;
- a wireless transceiver unit for radio link communication with an external device (20), preferably the secondary device (20),
characterized in that the add-on module (1) further comprises:
- a first serial connector (3) configured to receive a power load wire (5);
- a second serial connector (4) configured to be connected to a power load terminal (6) of the circuit breaker (2),
wherein the add-on module (1) is arrangeable in serial connection with the circuit breaker (2) by connecting the power load wire (5) for the terminal of the circuit breaker (2) to the first serial connector (3) and connecting the second serial connector (4) to the power load terminal (6) of the circuit breaker (2); and
- a first switch for switching the circuit breaker (2) between an active connected state and an inactive state, wherein the active state corresponds to a load in serial connection with the circuit breaker (2) being enabled and the inactive state corresponds to the load in serial connection with the circuit breaker (2) being disabled.

Since the circuit breakers on a rack are connected to electrical devices, such as consumer devices, controlling a circuit breaker also means that electrical devices, which constitute the power load of the circuit breaker, can be controlled remotely through for example a wireless interface and a smart phone application. Thus, the add-on module enables possibilities to provide real-time metering of power and current, as well as remote control of measured load and possibility to switch on and off electrical devices or groups of devices. As an example, the heating of a home could be controlled through the presently disclosed add-on module for a DIN rail-mounted electrical device.

One advantage of the add-on module is that it is simple to plug in to a mounted circuit breaker. A circuit breaker typically has input/output power load terminals for at least two cables, typically one on a top side or a bottom side of the electrical device. In order to mount the presently disclosed add-on module, one of the cables to the circuit breaker is pulled out from the connector. The add-on module may then be mounted to the circuit breaker as a serial extension by plugging the second serial connector directly into to a power load terminal of the electrical device, and plugging the removed cable into the first serial connector of the add-on module, which is configured to receive a power load wire. The mounting may thus be a very simple process. Smart circuit breakers and other similar DIN rail-mounted devices that are known in the art typically have the smart functions integrated in the device, which means that either the whole device has to be replaced or that internal functions of the device will have to manipulated. Preferably, the first serial connector is a female connector for receiving a corresponding male connector. The female connector may typically have an arrangement for retaining the power load wire once it has been inserted. The second serial connector may be a male connector that can be inserted into the power load terminal of the electrical device. The male connector is preferably rigid, such that it both connects the two devices and holds them together rigidly. The need for additional means for fixation of the add-on module is thereby reduced.

A further advantage of the add-on module for a DIN rail-mounted electrical device is that it operates outside the circuit breaker or electrical device. Therefore, existing and working circuit breakers do not have to be changed and the module does not have to interfere with the internal functions of the device.

These and other aspects of the invention are set forth in the following detailed description if the invention.

### Description of drawings

**Figs. 1A-B** show two embodiments of the add-on module for a DIN rail-mounted electrical device and possible serial mounting onto a circuit breaker.
**Fig. 2** shows an embodiment of the add-on module for a DIN rail-mounted electrical device having two (first) serial connectors configured to receive signal cables carrying input signals, in this case one phase signal and one neutral signal.
**Fig. 3** shows an embodiment of the add-on module for a DIN rail-mounted electrical device having an additional laterally arranged connector, configured to connect the add-on module to a neighboring add-on module.
**Fig. 4** shows an embodiment of the add-on module for a DIN rail-mounted electrical device having multiple connectors arranged with equal spacing between the connectors, allowing connection of several DIN units using one add-on module.
**Fig. 5** shows three add-on modules of the type showed in fig. 3, mounted on three circuit breakers, wherein the add-on modules are configured to communication internally between each other through the laterally arranged connectors.
**Figs. 6A-C** show different types of (first) connectors for receiving wires, such as power load wires.
**Fig. 7** show different types of (second) connectors for connecting the add-on module to a power load terminal of the electrical device.
**Fig. 8** shows three examples of internal configurations of the components of the add-on module for a DIN rail-mounted electrical device.
**Fig. 9** shows two add-on modules for a DIN rail-mounted electrical device and their internal configurations of components, wherein the modules are electrically connected to each other using a number of connectors.
**Fig. 10** shows three examples of internal configurations of the components of the add-on module for a DIN rail-mounted electrical device, the configurations comprising different types of sensors for measuring a current.
**Fig. 11** shows two examples of internal configurations of the components of the add-on module for a DIN rail-mounted electrical device, the configurations comprising different types of sensors for measuring a voltage. In the configuration the left, a module V is configured to measure the voltage difference between L and N. In the configuration the right, a module V is configured to measure and/or manipulate the three phase signals L1, L2 and L3.
**Fig. 12** shows an example of a system configuration, wherein the add-on modules for a DIN rail-mounted electrical device communicates with a central control device, and is part of a cloud solution, allowing the module to remotely controlled by any terminal.

### Detailed description of the invention

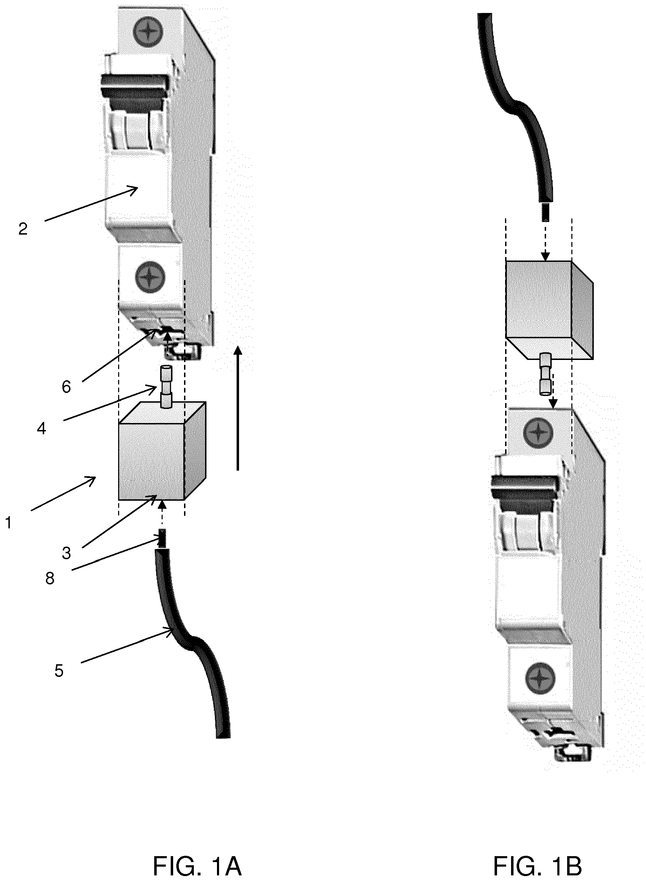

The present disclosure relates to an add-on module for a DIN rail-mounted electrical device, such as a circuit breaker, said add-on module configured to measure at least one electrical parameter of the electrical device. The add-on module comprises a microprocessor for recording and/or communicating at least one measured electrical parameter to a secondary device, such as a central device, and/or for controlling and/or adjusting a state of the electrical device. Typically, the add-on module also comprises at least one sensor configured to measure the electrical parameter. The add-on module further comprises means in the form of a connection unit, such as a wireless transceiver unit for radio link communication, for communication with an external device. The add-on module further comprises a first serial connector configured to receive a wire or cable, preferably a power load wire, and a second serial connector configured to be connected to a terminal, preferably a power load terminal, of the electrical device. The add-on module may be arranged as a serial extension of the DIN rail-mounted electrical device by removing a cable connected to the device, typically connected to the top side or bottom side of the DIN rail-mounted electrical device. The DIN rail is typically mounted horizontally in an equipment rack or DIN rail panel. The add-on module may be arranged in serial connection with the DIN rail-mounted electrical device, as shown in for example fig. 1, by connecting a wire such as a power load wire, originally going to the terminal of the electrical device, to the first serial connector, and by connecting the second serial output connector to the terminal of the electrical device, such as the power load terminal of the electrical device. The electrical device may be a circuit breaker, a miniature circuit breaker, residual-current device or any similar DIN-format unit.

The add-on module thereby provided a combination of a serial, mechanical connection to an existing and mounted circuit breaker and the measuring and control functionality provides an external module that has the smart capabilities that, in the known solutions, are integrated in the circuit breaker. The add-on module may operate as a plug-and-play module, i.e. the step of mounting and installing the add-on module in an existing rack with DIN rail-mounted electrical devices could be very simple for a user, basically only involving the steps of removing a serial cable to the DIN rail-mounted electrical devices and plugging the add-on module manually. Once the add-on module is serially connected to the electrical device, it could automatically perform an initialization process and connect itself to for example a home automation system. Preferably, the add-on module is remotely configurable and/or observable by an electronic interface, such as a smart phone application or a web application.

In order to avoid further mounting using for example screws or clips, it is preferred that the second serial connector, i.e. the connector to be connected to the power load terminal of the DIN rail-mounted electrical device, is designed such that it retains the add-on module in the connected position. This may be achieved using for example rigid connector with a shape or inherent flexibility such that when inserted into the power load terminal it does not easily fall off. The connection thereby also acts as mounting of the add-on module.

In one embodiment of the add-on module for a DIN rail-mounted electrical device, the module has a housing which can be arranged as a serial extension of a corresponding housing of the electrical device. This can be seen in for example fig. 1. In one embodiment the width of the module is equal to one DIN unit width.

The add-on module may be arranged to operate externally, independently of internal functions of the electrical device. An integrated solution inside the electrical device would have to take into account requirements in relation to functionality and safety. By operating outside of for example a circuit breaker, the main function of the circuit breaker, to interrupt current flow after a fault is detected, is not compromised.

The add-on module may further operate as a smart meter, providing real-time metering of power and current, as well as remote control of measured load and possibility to switch on and off electrical devices or groups of devices. The add-on module may also be configured to measure power consumption of a load in serial connection with the electrical device, such as a group of electrical devices. Therefore, in one embodiment of the presently disclosed add-on module for a DIN rail-mounted electrical device, the first serial connector is configured to receive a power load wire carrying a phase supply in a building. The first serial connector may for example be configured to receive a power load wire carrying a power supply signal between 0 and 400 V. IEC 60898-1 and European Standard EN 60898-1, define the rated current Iₙ of a circuit breaker for low voltage distribution applications as the maximum current that the breaker is designed to carry continuously (at an ambient air temperature of 30 °C). The commonly available preferred values for the rated current are 6 A, 10 A, 13 A, 16 A, 20 A, 25 A, 32 A, 40 A, 50 A, 63 A, 80 A, 100 A, and 125 A. The presently disclosed add-on module for a DIN rail-mounted electrical device may be configured for any of these rated currents.

The add-on module may comprise a current sensor, providing functionality such as that of an electricity meter. The current sensor may be configured to measure a current running through the electrical device. This can be achieved by means of for example a conventional DC or AC current measurement unit, preferably arranged to continuously measuring the instantaneous current through the device. The sensor may also be configured to measure any other electric property of a current flowing through a circuit breaker, such as an overload responsive circuit breaker and/or a miniature circuit breaker, a residual-current device, a contactor device, or a relay. The sensor may also comprise a Hall sensor or an induction coil for measuring a current without a physical connection to a power line connecting the first and second serial connectors internally in the add-on module.

In addition to measuring capabilities, the add-on module device for a DIN rail-mounted electrical device may be configured to switch on and off the serial connection by connecting/disconnecting the serial connection. This provides control, optionally automatic control, of any group of devices connected to a circuit breaker to which the add-on module is connected. The add-on model may thereby provide both remote supervision of a building and the ability to control groups of devices or specific device through circuit breakers in a circuit breaker box. A user may be able to better understand and control energy consumption in a building. The add-on module for a DIN rail-mounted electrical device, configured to switch on and off the serial connection by connecting/disconnecting the serial connection, may comprise a first switch for switching the device between an active connected state and an inactive state. The active state may thereby correspond to a load in serial connection with the electrical device being enabled and the inactive state corresponds to the load in serial connection with the electrical device being disabled. The add-on module may further comprising an actuator control, such as a dimmer, for providing continuous and/or linear control of the at least one electrical parameter of the electrical device. The add-on module may further comprise additional circuitry for manipulating a signal passing through the add-on module.

DIN rails come in a number of types, all of which are compatible with the presently disclosed add-on module for a DIN rail-mounted electrical device. There are three major types of DIN rails: a top hat section, type O, with a hat-shaped cross-section, the C section DIN rail, and the G section DIN rail. Typically the DIN rail is arranged horizontally, wherein electrical devices, such as circuit breakers are mounted on the DIN rail in a vertical direction. In such a configuration the add-on module may be connected to the top side or bottom side of the DIN rail-mounted electrical device. Preferably, the width, which is then defined as a horizontal distance, should be equal to or less than one DIN unit width, alternatively equal to or less than the width of the electrical device to which the add-on module is attached. In one embodiment, the add-on module has a width equal to or less than 18 mm.

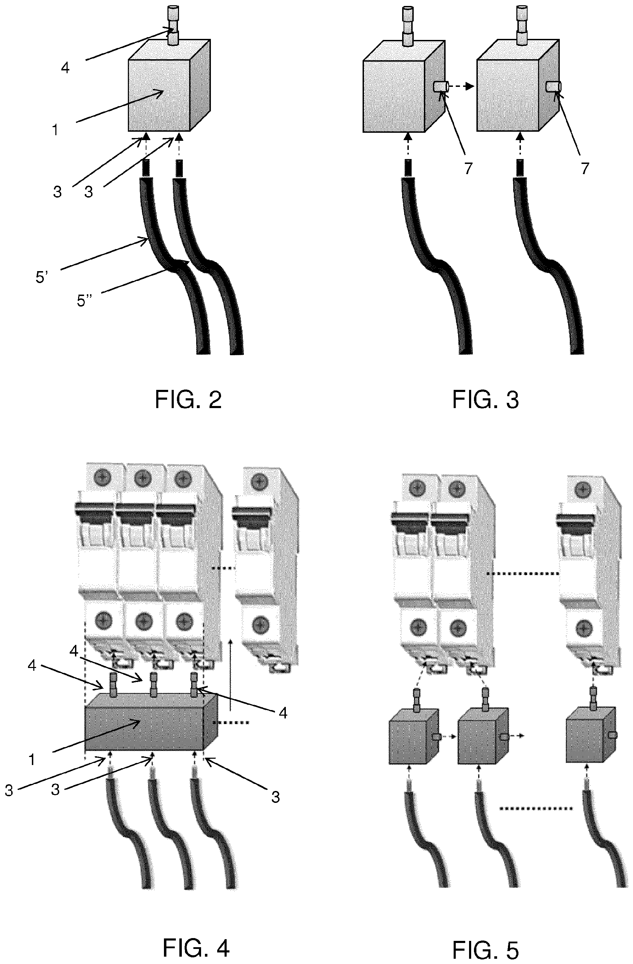

The presently disclosed add-on module for a DIN rail-mounted electrical device may be a modular device in the sense that it can also be connected to other neighboring add-on module. This can be achieved by a lateral connection as shown in for example fig. 5, and explained in further detail in the description of fig. 5. One embodiment of the add-on module for a DIN rail-mounted electrical device therefore comprises a bridging connector, preferably a laterally arranged connector, configured to connect the add-on module to a neighboring add-on module.

The first and second serial connectors provide the function of a serial extension of the DIN rail-mounted electrical device. Preferably, the first serial connector, which is the connector for receiving a wire, such as a power load wire, is a female connector for receiving a male connector or an end of a cable. The first serial connector may therefore have a terminal opening and a hollow body, such as a slot or a groove, for receiving the male connector or cable end. The first serial connector may moreover comprise a mechanism for retaining the cable. In a specific embodiment the end of the cable can be inserted a locked in a position from which it cannot be removed again. The first serial connector may also be identical to the electrical device onto which the add-on module is connected to ensure that the cable fits properly. The first serial connector may also be a screw connector.

The second serial connector is configured to be connected to a terminal of the electrical device, such as power load terminal of a circuit breaker. The second serial connector may fit a connector, such a screw connector and/or a female connector of the electrical device. Consequently, the second serial connector may be a male connector and the power load terminal of the electrical device is a corresponding female connector and/or a screw terminal. In a specific embodiment the second serial connector is a pin that can be inserted into, and preferably locked in, a receiving connector of the DIN rail-mounted electrical device. The second serial connector may alternatively be described as a protruding element arranged to fit a power load terminal of the electrical device.

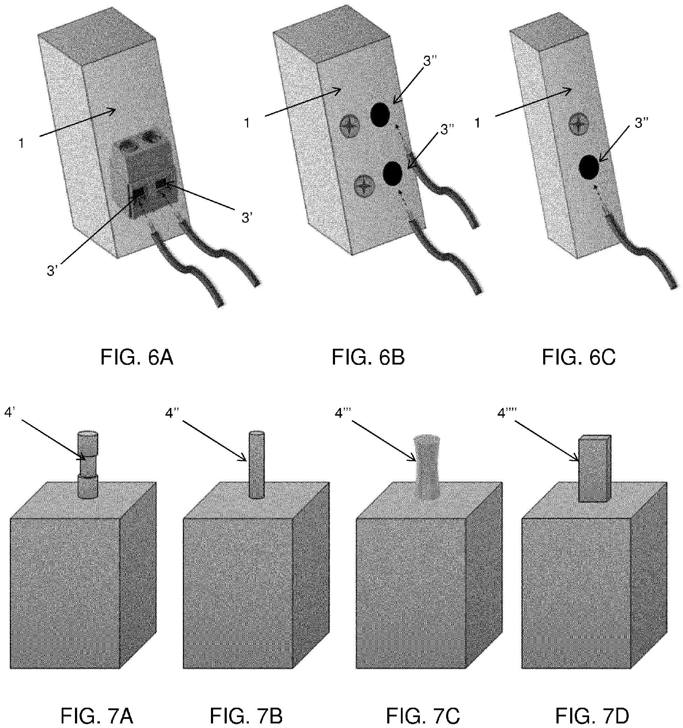

A number of shapes of the second serial connector are possible, some of which are shown in figs. 7A-D. In one embodiment, the protruding element is substantially cylindrical. In another embodiment, the protruding element comprises a proximal section, a distal section and a middle section between the proximal and distal sections, wherein the middle section is narrower than the proximal and distal sections. The protruding element may also be gradually wider towards a distal end of the protruding element. The protruding element may also have narrower middle section, or a design having a narrower middle section and being gradually wider towards a proximal end and a distal end of the protruding element. Preferably, the protrusion element is configured such that it holds the electrical device and the add-on module together rigidly such that the add-on module constitutes a serial extension of the electrical device. The need for additional means for fixation of the add-on module is thereby reduced. The add-on module may for example by snapped or clicked to an inserted and locked position such that it cannot be removed from the electrical device without involving a further release mechanism.

The add-on module may further comprise a third (optionally a fourth, fifth etc.) serial connector configured to receive an additional power load wire. If for example the circuit breaker receives one phase wire and one neutral wire, the add-on module would accordingly have to comprise two connectors for receiving these. The add-on unit may also be configured for monitoring three phases of power supply. In such a solution the add-on module may require three connectors for receiving the three phases, optionally with additional connector for for example neutral phase and ground cables. Therefore, one embodiment of the presently disclosed add-on module for a DIN rail-mounted electrical device further comprises a third serial connector configured to receive a power load wire. The first serial connector may be configured to receive a neutral wire and the third serial connector is configured to receive a first phase signal wire. The add-on module may further comprise a third and a fourth serial connector configured to receive a second phase signal wire and a third phase signal wire of a three-phase electric power signal.

The at least one sensor, the microprocessor and the connection unit need power to operate. The add-on module therefore comprises a power supply unit for providing electric power to the at least one sensor, the microprocessor and the connection unit. The power supply unit may be an internal battery, preferably a rechargeable battery, and/or an energy harvesting supply unit, preferably configured to harvest energy from the power load wire, or a combination. A power signal may also have the function of starting an initialization process of the add-on module such that when the module is plugged in, it automatically connects, or at least becomes visible to a wireless network. The add-on module may thereby, in one embodiment, be considered a plug and play device both in the sense that it provides a mechanical solution for connecting it to a circuit breaker and that it connects automatically or semi-automatically to a system (for example by acceptance by the system or user).

The connection unit may be a wired or wireless connect unit. In one embodiment the communication unit comprises a wireless transceiver unit for radio link communication, wherein the wireless transceiver unit comprises an antenna. The wireless transceiver may be configured to send information measured by the add-on module and to receive information for controlling for example the switch between the active and inactive states

### Detailed description of drawings

The invention will in the following be described in greater detail with reference to the accompanying drawings. The drawings are exemplary and are intended to illustrate some of the features of the presently disclosed add-on module for a DIN rail-mounted electrical device, and are not to be construed as limiting to the presently disclosed invention.

Figs. 1A-B show two embodiments of the add-on module (1) for a DIN rail-mounted electrical device (2) and possible serial mounting onto a circuit breaker. The add-on module (1) provides a connector (4) configured to be connected to a power load terminal (6) that fits into an existing terminal connector of the circuit breaker (2). The module (1) has first serial connector (3) configured to receive a power load wire (5) having a cable end (8). This allows the module (1) to interact with a signal of cable (5) by for example interrupting it, modulating it, applying dimming function etc.

Fig. 2 shows an embodiment of the add-on module (1) for a DIN rail-mounted electrical device having two (first) serial connectors (3) configured to receive signal cables (5', 5") carrying input signals, in this case one phase signal and one neutral signal.

Fig. 3 shows an embodiment of the add-on module (1) for a DIN rail-mounted electrical device having an additional laterally arranged connector (7), configured to connect the add-on module to a neighboring add-on module. In this configuration commands can be issued between the neighboring add-on modules resulting in control actions or measurements.

Fig. 4 shows an embodiment of the add-on module (1) for a DIN rail-mounted electrical device having multiple connectors (3, 4) arranged with equal spacing between the connectors, allowing connection of several DIN units using one add-on module. This allows concurrently monitoring and manipulating three phases of power supply, for example switching of the three phases.

Fig. 5 shows three add-on modules (1) of the type showed in fig. 3, mounted on three circuit breakers, wherein the add-on modules are configured to communication internally between each other through the laterally arranged connectors (7). This flexible approach allows manufacturing of one type on unit that then can be adapted to any size and number of connectors to DIN modules.

Figs. 6A-C show different types of (first) connectors (3', 3") for receiving wires, such as power load wires. The module of fig. 6A accepts two signals using a standard terminal connection that is plugged in externally from the unit. The module of fig. 6B accepts two signals into terminal connections that are integral to the unit. The module of fig. 6C accepts only one signal. This can be either internal as shown in the figure or using an externally located standard terminal connection. The terminal connections are most conveniently located on the opposite side from the connector to the DIN unit, but could also be located on any side of the unit.
Fig. 7 show different types of (second) connectors (4', 4", 4"', 4"") for connecting the add-on module to a power load terminal of the electrical device. Fig. 7A shows a connector (4') having a narrower middle cylinder shape between two wider cylinder shapes allowing the typical screws of a screw terminal connection to securely fasten to a DIN-monted electrical device. Fig. 7B shows a cylindrical connector (4"). Fig. 7C shows a connector (4"') which is gradually narrower towards the middle and wider towards the ends, allowing secure fastening of the module in typical terminal connections. Fig. 7D shows a connector (4"') having a cross-section in the form of a square with a flat shape providing a wider connector for secure fastening.

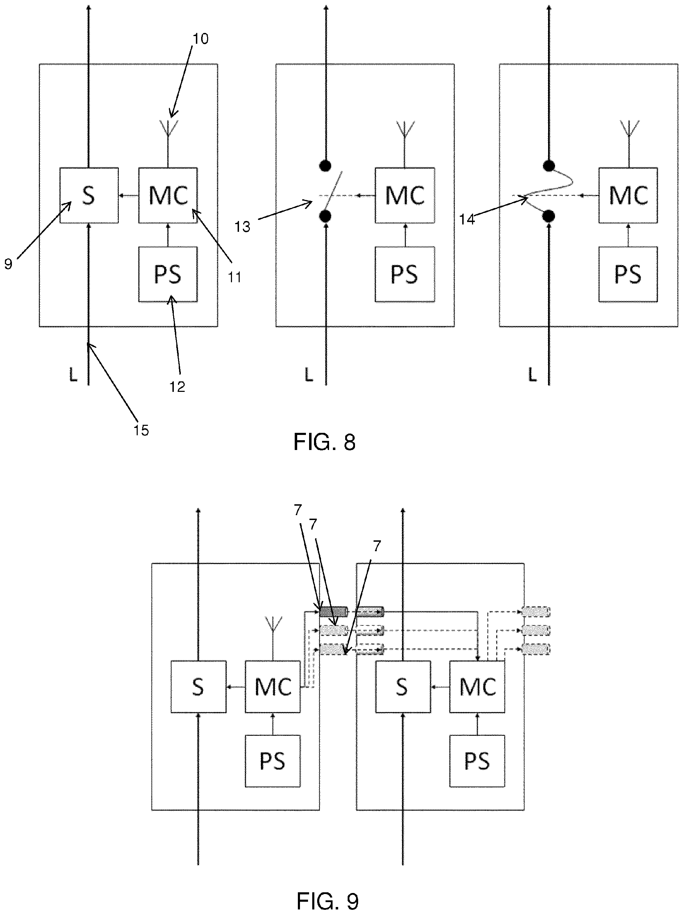

Fig. 8 shows three examples of internal configurations of the components of the add-on module for a DIN rail-mounted electrical device.One input signal (15) is a phase power feed. The module comprises a module S (9) for manipulating the signal L, a power supply PS (12) and a microcontroller MC. The microcontroller MC either has connection to radio for communication or a wired signal communication. MC controls actions of the module, monitoring signals and issuing commands.

Fig. 9 shows two add-on modules for a DIN rail-mounted electrical device and their internal configurations of components, wherein the modules are electrically connected to each other using a number of connectors (7). Only one of the two add-on modules need a radio communication unit in this case since the modules can communicate internally.

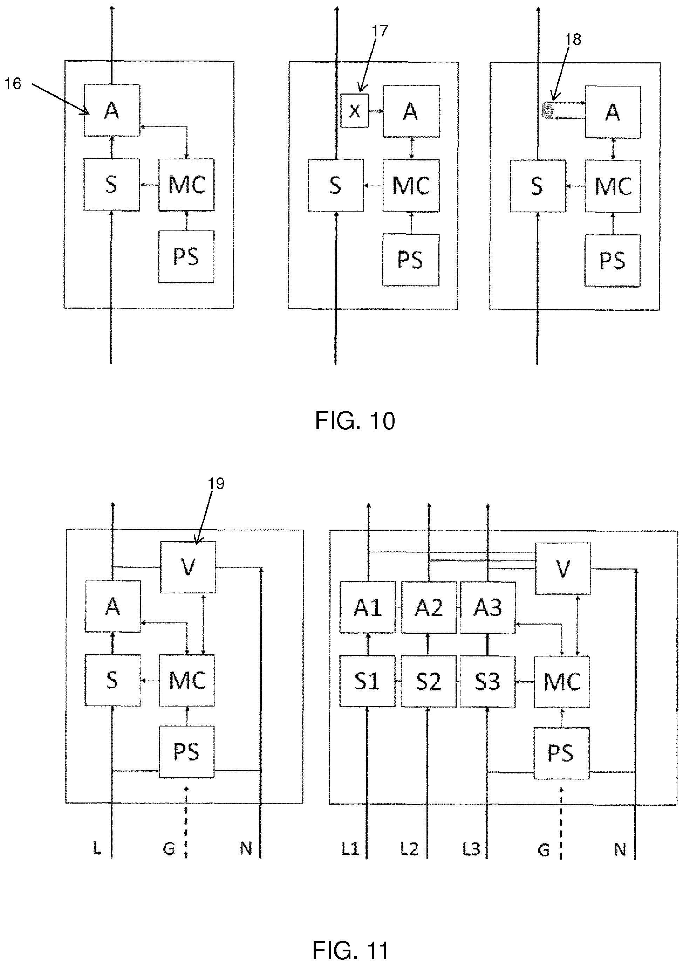

Fig. 10 shows three examples of internal configurations of the components of the add-on module for a DIN rail-mounted electrical device, the configurations comprising different types of sensors for measuring a current. In the leftmost configuration the module comprises a module A (16) for current measurements of the signal running through the module. The measured current is observed by microcontroller MC and transmitted to overlying systems using radio or signal cable. In the center configuration the module comprises a Hall effect sensor (17) for measurement of current giving reasonable resolution for a smart home application. In the rightmost configuration the module comprises an induction coil (18) that can be either wrapped around the signal or placed nearby for measurement of the current flowing in the signal without interfering with the signal and achieving a high resolution.

Fig. 11 shows two examples of internal configurations of the components of the add-on module for a DIN rail-mounted electrical device, the configurations comprising different types of sensors (19) for measuring a voltage. In the configuration the left, a module V is configured to measure the voltage difference between L and N. In the configuration the right, a module V is configured to measure and/or manipulate the three phase signals L1, L2 and L3. In the right figure, the microprocessor MC analyses the measurements from V, S1, S2 and S3, allowing a multitude of analytics of the voltage and current signals to be transmitted to overlying systems.

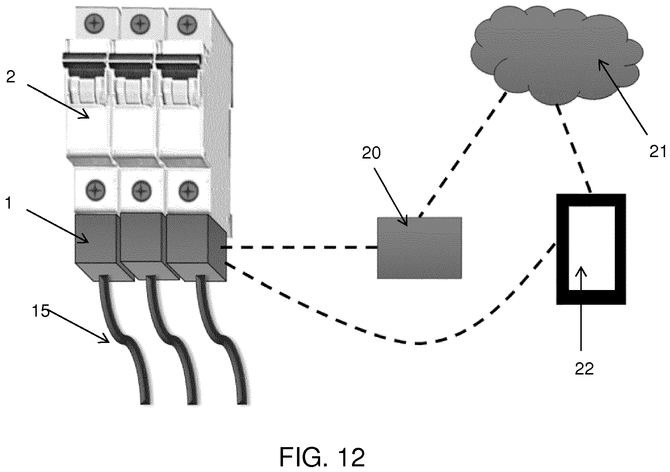

Fig. 12 shows an example of a system configuration, wherein the add-on modules (1) for a DIN rail-mounted electrical device (2) communicates with a central control device (20), and is part of a cloud solution (21), allowing the module to remotely controlled by any terminal (22). The communication can be based on for example Zigbee. To allow control of the add-on modules (1) remotely, a module (20) can be used to relay the message to remote communication terminals. The module (20) can be for example a WiFi router or a Zigbee gateway. The communication can be translated to another protocol or mode of communication that is routed remotely through Internet or similar remote networks. There can be computer servers located on this network that form a cloud solution, keeping the add-on modules remotely available through a communication interface. This allows the add-on modules (1) to be remotely controllable through different types of user terminals, for example mobile phones and computers. Through the user terminals the add-on modules (1) could be programmed, assigned schedules and settings when to act and when to report data to the user terminals. Direct control for manipulating the signals (15) in real time and monitoring may also be possible.

## Claims

1. An add-on module (1) for a DIN rail-mounted circuit breaker (2), said add-on module configured to measure at least one electrical parameter of the circuit breaker (2), comprising:
- at least one sensor (19) configured to measure the at least one electrical parameter;
- a microprocessor (MC) for communicating the at least one electrical parameter to a secondary device (20), and for controlling a state of the circuit breaker;
- a wireless transceiver unit for radio link communication with an external device (20), preferably the secondary device (20),
**characterized in that** the add-on module (1) further comprises:
- a first serial connector (3) configured to receive a power load wire (5);
- a second serial connector (4) configured to be connected to a power load terminal (6) of the circuit breaker (2),
wherein the add-on module (1) is arrangeable in serial connection with the circuit breaker (2) by connecting the power load wire (5) for the terminal of the circuit breaker (2) to the first serial connector (3) and connecting the second serial connector (4) to the power load terminal (6) of the circuit breaker (2); and
- a first switch for switching the circuit breaker (2) between an active connected state and an inactive state, wherein the active state corresponds to a load in serial connection with the circuit breaker (2) being enabled and the inactive state corresponds to the load in serial connection with the circuit breaker (2) being disabled.

2. The add-on module (1) according to any of the preceding claims, wherein the first serial connector (3) comprises a terminal opening and a hollow body, preferably a female connector for receiving a corresponding male connector.

3. The add-on module (1) according to any of the preceding claims wherein the second serial connector (4) is a male connector and the power load terminal (6) of the circuit breaker (2) is a corresponding female connector and/or a screw terminal.

4. The add-on module (1) according to any of the preceding claims, wherein the second serial connector (4) is a pin.

5. The add-on module (1) according to any of the preceding claims, wherein the second serial connector (4) comprises a protruding element arranged to fit the power load terminal (6) of the circuit breaker (2).

6. The add-on module (1) according to claim 5, wherein the protruding element comprises a proximal section, a distal section and a middle section between the proximal and distal sections, wherein the middle section is narrower than the proximal and distal sections.

7. The add-on module (1) according to any of claims 5-6, wherein the protruding element is a flex pin connector.

8. The add-on module (1) according to any of the preceding claims, further comprising a power supply unit (12) for providing electric power to the at least one sensor (19), the microprocessor (MC) and the wireless transceiver unit, wherein the power supply unit (12) is a batteryor an energy harvesting supply unit configured to harvest energy from the power load wire (5).

9. The add-on module (1) according to any of the preceding claims, further comprising a bridging connector, configured to connect the add-on module to a neighboring add-on module.

10. The add-on module (1) according to any of the preceding claims, said add-on module configured to be plugged into a top side or a bottom side of the circuit breaker (2).

11. The add-on module (1) according to any of the preceding claims, further comprising a housing arrangeable as a serial extension of a housing of the circuit breaker.

12. The add-on module (1) according to any of the preceding claims, wherein the add-on module is arranged to operate externally, independently of internal functions of the circuit breaker.

## Patentansprüche

1. Zusatzmodul (1) für einen an einer DIN-Schiene montierten Leistungsschalter (2), wobei das Zusatzmodul dazu konfiguriert ist, mindestens einen elektrischen Parameter des Leistungsschalters (2) zu messen, umfassend:
- mindestens einen Sensor (19), der dazu konfiguriert ist, den mindestens einen elektrischen Parameter zu messen,
- einen Mikroprozessor (MC) zum Kommunizieren des mindestens einen elektrischen Parameters an eine sekundäre Vorrichtung (20) und zum Steuern eines Zustands des Leistungsschalters;
- eine drahtlose Transceiver-Einheit zur Funkverbindungskommunikation mit einer externen Vorrichtung (20), bevorzugt der sekundären Vorrichtung (20),
**dadurch gekennzeichnet, dass** das Zusatzmodul (1) ferner Folgendes umfasst:
- einen ersten seriellen Verbinder (3), der dazu konfiguriert ist, einen Stromlastdraht (5) aufzunehmen;
- einen zweiten seriellen Verbinder (4), der dazu konfiguriert ist, mit einem Stromlastanschluss (6) des Leistungsschalters (2) verbunden zu werden,
wobei das Zusatzmodul (1) in einer seriellen Verbindung mit dem Leistungsschalter (2) angeordnet werden kann, indem der Stromlastdraht (5) für den Anschluss des Leistungsschalters (2) mit dem ersten seriellen Verbinder (3) verbunden wird und der zweite serielle Verbinder (4) mit dem Stromlastanschluss (6) des Leistungsschalters (2) verbunden wird; und
- einen ersten Schalter zum Umschalten des Leistungsschalters (2) zwischen einem aktiven verbunden Zustand und einem inaktiven Zustand, wobei der aktive Zustand dem entspricht, dass eine Last in serieller Verbindung mit dem Leistungsschalter (2) aktiviert wird, und der inaktive Zustand dem entspricht, dass die Last in serieller Verbindung mit dem Leistungsschalter (2) deaktiviert wird.

2. Zusatzmodul (1) nach einem der vorangehenden Ansprüche, wobei der erste serielle Verbinder (3) eine Anschlussöffnung und einen Hohlkörper umfasst, bevorzugt einen weiblichen Verbinder zum Aufnehmen eines entsprechenden männlichen Verbinders.

3. Zusatzmodul (1) nach einem der vorangehenden Ansprüche, wobei der zweite serielle Verbinder (4) ein männlicher Verbinder ist und der Stromlastanschluss (6) des Leistungsschalters (2) ein entsprechender weiblicher Verbinder und/oder ein Schraubanschluss ist.

4. Zusatzmodul (1) nach einem der vorangehenden Ansprüche, wobei der zweite serielle Verbinder (4) ein Stift ist.

5. Zusatzmodul (1) nach einem der vorangehenden Ansprüche, wobei der zweite serielle Verbinder (4) ein vorstehendes Element umfasst, das so angeordnet ist, dass es zu dem Stromlastanschluss (6) des Leistungsschalters (2) passt.

6. Zusatzmodul (1) nach Anspruch 5, wobei das vorstehende Element einen proximalen Abschnitt, einen distalen Abschnitt und einen mittleren Abschnitt zwischen dem proximalen und dem distalen Abschnitt umfasst, wobei der mittlere Abschnitt schmaler ist als der proximale und der distale Abschnitt.

7. Zusatzmodul (1) nach einem der Ansprüche 5-6, wobei das vorstehende Element ein flexibler Stiftverbinder ist.

8. Zusatzmodul (1) nach einem der vorangehenden Ansprüche, ferner umfassend eine Leistungsversorgungseinheit (12) zum Bereitstellen von elektrischer Leistung an den mindestens einen Sensor (19), den Mikroprozessor (MC) und die drahtlose Transceiver-Einheit, wobei die Leistungsversorgungseinheit (12) eine Batterie oder eine Energiegewinnungs-Versorgungseinheit ist, die dazu konfiguriert ist, Energie von dem Stromlastdraht (5) zu gewinnen.

9. Zusatzmodul (1) nach einem der vorangehenden Ansprüche, ferner umfassend einen Brückenverbinder, der dazu konfiguriert ist, das Zusatzmodul mit einem benachbarten Zusatzmodul zu verbinden.

10. Zusatzmodul (1) nach einem der vorangehenden Ansprüche, wobei das Zusatzmodul dazu konfiguriert ist, in eine obere Seite oder eine untere Seite des Leistungsschalters (2) eingesteckt zu werden.

11. Zusatzmodul (1) nach einem der vorangehenden Ansprüche, ferner umfassend ein Gehäuse, das als serielle Erweiterung eines Gehäuses des Leistungsschalters angeordnet werden kann.

12. Zusatzmodul (1) nach einem der vorangehenden Ansprüche, wobei das Zusatzmodul dazu angeordnet ist, extern betrieben zu werden, unabhängig von internen Funktionen des Leistungsschalters.

## Revendications

1. Module complémentaire (1) pour un disjoncteur monté sur rail DIN (2), ledit module complémentaire étant configuré pour mesurer au moins un paramètre électrique du disjoncteur (2), comprenant :
- au moins un capteur (19) configuré pour mesurer l'au moins un paramètre électrique ;
- un microprocesseur (MC) destiné à communiquer l'au moins un paramètre électrique à un dispositif secondaire (20), et à contrôler un état du disjoncteur ;
- une unité d'émission-réception sans fil pour une communication par liaison radio avec un dispositif externe (20), de préférence le dispositif secondaire (20),
**caractérisé en ce que** le module complémentaire (1) comprend en outre :
- un premier connecteur série (3) configuré pour recevoir un fil de charge d'alimentation (5) ;
- un second connecteur série (4) configuré pour être connecté à une borne de charge d'alimentation (6) du disjoncteur (2), dans lequel le module complémentaire (1) peut être agencé en connexion série avec le disjoncteur (2) en connectant le fil de charge d'alimentation (5) pour la borne du disjoncteur (2) au premier connecteur série (3) et en connectant le second connecteur série (4) à la borne de charge d'alimentation (6) du disjoncteur (2) ; et
- un premier commutateur pour commuter le disjoncteur (2) entre un état connecté actif et un état inactif, dans lequel l'état actif correspond à une charge en connexion série avec le disjoncteur (2) étant activée et l'état inactif correspond à la charge en connexion série avec le disjoncteur (2) étant désactivée.

2. Module complémentaire (1) selon l'une quelconque des revendications précédentes, dans lequel le premier connecteur série (3) comprend une ouverture de borne et un corps creux, de préférence un connecteur femelle pour recevoir un connecteur mâle correspondant.

3. Module complémentaire (1) selon l'une quelconque des revendications précédentes, dans lequel le second connecteur série (4) est un connecteur mâle et la borne de charge d'alimentation (6) du disjoncteur (2) est un connecteur femelle et/ou une borne à vis correspondant(e).

4. Module complémentaire (1) selon l'une quelconque des revendications précédentes, dans lequel le second connecteur série (4) est une broche.

5. Module complémentaire (1) selon l'une quelconque des revendications précédentes, dans lequel le second connecteur série (4) comprend un élément en saillie agencé pour s'adapter à la borne de charge d'alimentation (6) du disjoncteur (2).

6. Module complémentaire (1) selon la revendication 5, dans lequel l'élément en saillie comprend une section proximale, une section distale et une section intermédiaire entre les sections proximale et distale, dans lequel la section intermédiaire est plus étroite que les sections proximale et distale.

7. Module complémentaire (1) selon l'une quelconque des revendications 5 et 6, dans lequel l'élément en saillie est un connecteur à broche flexible.

8. Module complémentaire (1) selon l'une quelconque des revendications précédentes, comprenant en outre une unité d'alimentation (12) destinée à fournir une alimentation électrique à l'au moins un capteur (19), au microprocesseur (MC) et à l'unité d'émission-réception sans fil, dans lequel l'unité d'alimentation (12) est une batterie ou une unité d'alimentation à collecte d'énergie configurée pour collecter l'énergie du fil de charge d'alimentation (5).

9. Module complémentaire (1) selon l'une quelconque des revendications précédentes, comprenant en outre un connecteur de pontage, configuré pour connecter le module complémentaire à un module complémentaire voisin.

10. Module complémentaire (1) selon l'une quelconque des revendications précédentes, ledit module complémentaire étant configuré pour être branché dans un côté supérieur ou un côté inférieur du disjoncteur (2).

11. Module complémentaire (1) selon l'une quelconque des revendications précédentes, comprenant en outre un boîtier pouvant être agencé sous forme d'une extension série d'un boîtier du disjoncteur.

12. Module complémentaire (1) selon l'une quelconque des revendications précédentes, dans lequel le module complémentaire est conçu pour fonctionner de manière externe, indépendamment de fonctions internes du disjoncteur.
